# EUROPEAN PATENT APPLICATION

(11) **EP 1 202 327 A1**
(43) Date of publication of application: **02.05.2002**
(21) Application number: 01125313.5
(22) Date of filing: 25.10.2001
(51) Int. Cl.: H01L 21/00, H01L 21/20, H01L 33/00, H01L 31/0232

(54) **Semiconductor device**

(30) Priority: 31.10.2000 JP 2000332764
(71) Applicant: Disco Corporation, Ota-ku, Tokyo 144-8650 (JP)
(72) Inventor: Sekiya, Kazuma, Ota-ku, Tokyo 144-8650 (JP)
(74) Representative: Müller-Boré & Partner Patentanwälte

(57) **Abstract**

A semiconductor device comprising a support substrate and a semiconductor chip mounted on the support substrate. The semiconductor chip has a thickness of 20 to 100 µm, particularly 30 to 50 µm, and can be curved. The semiconductor chip is kept curved with a predetermined curvature by it being mounted on the support substrate.

## Description

### Field of the Invention

The present invention relates to a semiconductor device comprising a support means and a semiconductor chip mounted on the support means.

### Description of the Prior Art

As known to people of ordinary skill in the art, in the production of a semiconductor device, a semiconductor circuit is formed in each of a large number of rectangular regions sectioned by linear streets arranged on the front surface of a semiconductor wafer in a lattice form. Generally speaking, after semiconductor circuits have been formed on the front surface of a wafer, the back surface of the semiconductor wafer is ground to reduce the thickness of the semiconductor wafer to a predetermined thickness and then the semiconductor wafer is cut from its front surface along the streets to separate a large number of rectangular regions from one another, thereby forming a large number of semiconductor chips from the separated rectangular regions. In these days, prior to the grinding of the back surface of a semiconductor wafer, grooves are formed by cutting the front surface of the semiconductor wafer along streets to a predetermined depth that is not the entire thickness of the semiconductor wafer and then, the back surface of the semiconductor wafer is ground to make the thickness of the semiconductor wafer smaller than the depth of the above grooves to separate a large number of rectangular regions from one another, thereby forming a large number of semiconductor chips from the separated rectangular regions. A method in which grooves having a predetermined depth are formed in the front surface of a semiconductor along streets prior to the grinding of the back surface of the semiconductor wafer is called "dice-before-grind method".

The semiconductor chips are mounted on a support means which may be a flat plate and a semiconductor device is thus produced. The semiconductor wafer is an uncurved flat plate, and semiconductor chips obtained by cutting a semiconductor wafer along streets are also uncurved flat plates.

The inventor of the present invention has, however, conducted intensive analysis and studies on a semiconductor device used for various purposes and as a result, it has been found that in a semiconductor device used for a specific purpose, if a semiconductor chip is not a flat plate and is curved with a predetermined curvature, a marked advantage can be obtained compared with a semiconductor device comprising a semiconductor chip which is a flat plate. For example, if a semiconductor chip constituting a CCD (charge coupled device) used as an imager or imaging means is curved with a predetermined curvature, an image distortion ascribed to a optical means for projecting an image onto the imaging means can be suitably compensated. Further, when each of a plurality of semiconductor chips for emitting a laser beam is curved with a predetermined curvature, laser beams emitted from the plurality of semiconductor chips can be converged at one point without using a large number of optical elements.

### Summary of the Invention

It is therefore a principal object of the present invention to provide a novel semiconductor device comprising a semiconductor chip which is curved with a predetermined curvature.

The inventor of the present invention has found that, for example, a semiconductor chip formed by separating a silicon wafer into rectangular regions can be curved by making its thickness fully small, and that the above principal object can be attained by mounting the semiconductor chip on suitable support means to keep it with a predetermined curvature.

That is, according to the present invention, there is provided a semiconductor device comprising a support means and a semiconductor chip mounted on the support means, wherein the semiconductor chip has a capability of being curved, and is kept curved with a predetermined curvature by it being mounted on the support means.

Preferably, the support means has a curved surface with a predetermined curvature, the semiconductor chip is curved so that it extends along the curved surface, and the back surface of the semiconductor chip is at least partially bonded to the curved surface by a bonding material. Preferably, the entire back surface of the semiconductor chip is bonded to the curved surface by a bonding material. Preferably, the semiconductor chip is made from silicon having a thickness of 20 to 100 µm, particularly preferably 30 to 50 µm.

### Brief Description of the Drawings

Fig. 1 is a side view of an embodiment of a semiconductor device constituted according to the present invention;
Fig. 2 is a perspective view of a silicon wafer used to form a semiconductor chip in the semiconductor device of Fig. 1;
Fig. 3 is a schematic diagram showing a method in which grooves having a predetermined depth are formed along streets in the front surface of the silicon wafer of Fig. 2;
Fig. 4 is a schematic diagram showing a method in which after grooves having a predetermined depth are formed along streets in the front surface of the silicon wafer of Fig. 2, the back surface of the above silicon wafer is ground;
Fig. 5 is a side view of another embodiment of a semiconductor device constituted according to the present invention; and
Fig. 6 is a side view of still another embodiment of a semiconductor device constituted according to the present invention.

### Detailed Description of the Preferred Embodiments

Preferred embodiments of a semiconductor device constituted according to the present invention will be described in detail with reference to the accompanying drawings.

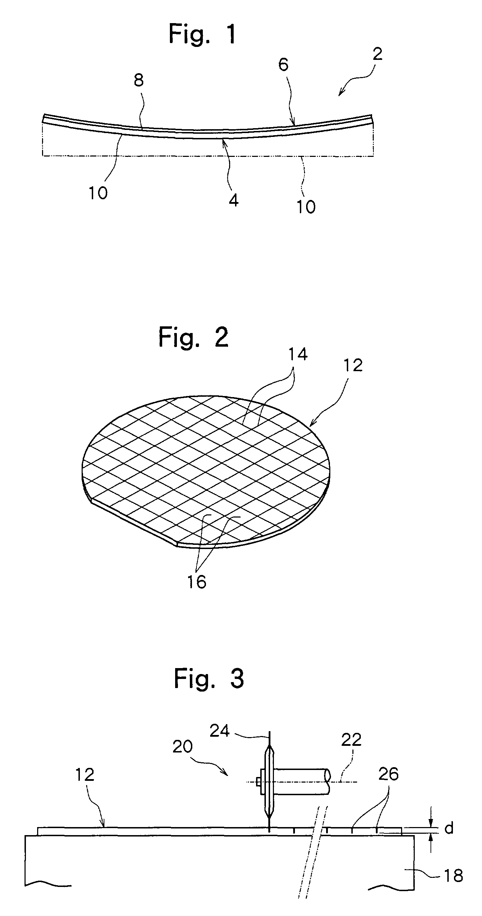

Fig. 1 illustrates a preferred embodiment of a semiconductor device 2 constituted according to the present invention. The illustrated semiconductor device 2 comprises a support means 4 and a semiconductor chip 6. It is important that the support means 4 have a curved surface with a predetermined curvature. The illustrated support means 4 has an arcuate cross sectional form and two surfaces with a predetermined curvature, that is, an arcuate upper surface 8 and an arcuate lower surface 10. The support means 4 may be formed from a suitable material such as glass, ceramic or synthetic resin. It is important that the semiconductor chip 6 be fully thin and able to be curved. In the illustrated embodiment, the semiconductor chip 6 is kept curved in conformity to the upper surface 8 of the support means 4 by bonding the back surface thereof to the upper surface 8 of the support means 4. The entire area of the back surface of the semiconductor chip 6 is preferably bonded to the upper surface 8 of the support means 4 by a bonding material. The bonding material may be a suitable adhesive or solder. If desired, only a meshed area or a large number of point areas and not the entire area of the back surface of the semiconductor chip 4 may be bonded to the upper surface of the support means 4 by a bonding material.

In the embodiment shown in Fig. 1, the back surface of the semiconductor chip 6 is bonded to the upper surface 8 of the support means 4 and accordingly, the front surface of the semiconductor chip 6 has a shape of concave. If desired, the front surface of the semiconductor chip 6 may be convexed by bonding the back surface of the semiconductor chip 6 to the lower surface of the support means 4. As shown by a two-dotted chain line in Fig. 1, the lower surface 10 not bonded to the semiconductor chip 6 of the support means 4 may be made flat.

One of the preferred methods of forming the semiconductor chip 6 which can be curved is as follows. Fig. 2 shows a silicon wafer 12 as a typical example of a semiconductor wafer. A large number of rectangular regions 16 are sectioned by linear streets 14 formed on the front surface of this silicon wafer 12 in a lattice form. In each of the rectangular regions 16, a suitable semiconductor circuit is formed. As shown in Fig. 3, the silicon wafer 12 is fixed to a table 18 in such a manner that its front surface faces up. The silicon wafer 12 can be fixed to the table 18 by vacuum adsorption. The silicon wafer 12 is cut along the streets 14 by a rotary cutter 20. The rotary cutter 20 which is rotated on a center axis 22 at a high speed has a cutting blade 24 formed by bonding diamond grains with a suitable bonding agent. Cutting with the rotary cutter 20 is not carried out to the entire thickness of the silicon wafer 12 but is carried out to a predetermined depth "d" from the front surface of the silicon wafer. Therefore, a large number of grooves 26 having a depth "d" from the front surface are formed along the streets 14 in the silicon wafer 12. Since cutting of the silicon wafer 12 with the rotary cutter 20 is known to people of ordinary skill in the art, its detailed description is omitted.

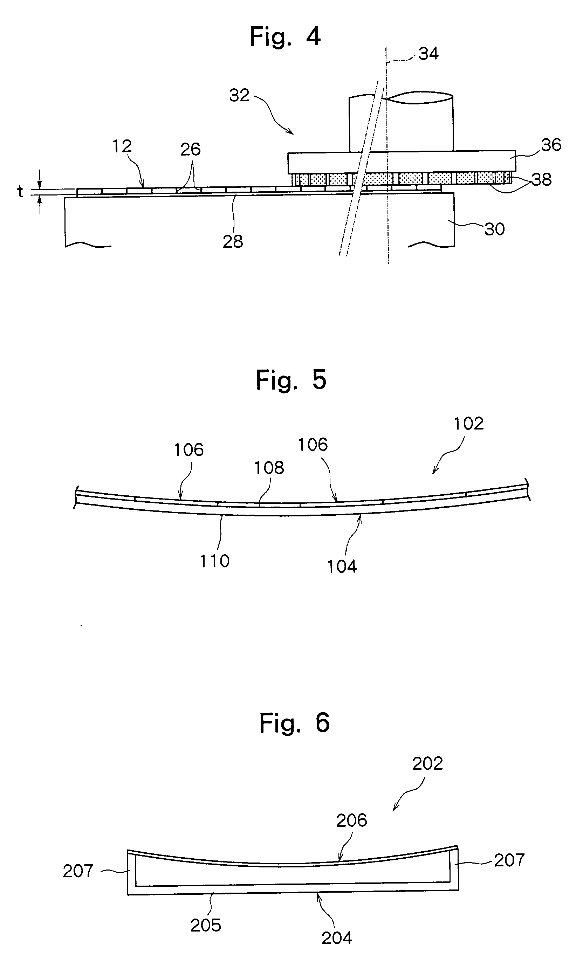

Thereafter, as shown in Fig. 4, a protective film 28 which may be a synthetic resin film is affixed to the front surface of the silicon wafer 12. The silicon wafer 12 is fixed on a rotary table 30 in such a manner that its back surface faces up. While the rotary table 30 is caused to be rotated at a relatively low speed, a rotary grinder 32 which is caused to be rotated at a relatively high speed is applied to the back surface of the silicon wafer 12 to grind the back surface of the silicon wafer 12. The rotary grinder 32 which is rotated on a center axis 34 comprises an annular support member 36 and a large number of grinding members 38 mounted on the lower surface of the support member 36. The grinding members 38 are arcuate and spaced apart from one another in a circumferential direction. The grinding members 38 are formed by bonding diamond grains with a suitable bonding agent. Since grinding of the back surface of the silicon wafer 12 with the rotary grinder 32 is known to people of ordinary skill in the art, its detailed description is omitted. When the back surface of the silicon wafer 12 is ground with the rotary grinder 32 to make the thickness "t" of the silicon wafer 12 smaller than the depth "d" of the above grooves 26, the silicon wafer 12 is separated into a large number of rectangular regions 16. The separated rectangular regions 16 are each removed from the protective film 28 to thereby form semiconductor chips 6. According to the experience of the inventor of the present invention, when the thickness "t" of the silicon wafer 12 is reduced to 20 to 100 µm, particularly 30 to 50 µm, a semiconductor chip 4 which can be suitably curved without being broken can be formed. When the thickness "t" is too large, it tends to be broken at the time when the semiconductor chip 4 is to be curved. When the thickness "t" is too low, the stiffness of the semiconductor chip 4 becomes too small. It is not impossible but considerably difficult to make the thickness "t" too small.

Fig. 5 shows another embodiment of a semiconductor device constituted according to the present invention. In the semiconductor device 102 shown in Fig. 5, a plurality of semiconductor chips 106 are mounted on a common support means 104. Describing in more detail, the support means 104 has an arcuate cross sectional form and an arcuate upper surface 108 and an arcuate lower surface 110. The back surfaces of the plurality of semiconductor chips 106 which can be curved are bonded to the upper surface 108 of the support means 104 so that each of the semiconductor chips 106 is kept curved in conformity to the upper surface 108 of the support means 104. The plurality of semiconductor chips 106 may be arranged in parallel on the upper surface 108 of the support means 104 in such a manner that their side ends are in contact with, or close to, one another.

Fig. 6 shows still another embodiment of a semiconductor device constituted according to the present invention. The semiconductor device 202 shown in Fig. 6 comprises a support means 204 and a semiconductor chip 206. The support means 204 has a bottom wall portion 205 extending substantially flat and two upright wall portions 207 extending upward from both side ends of the bottom wall portion 205. The top end surfaces of the upright wall portions 207 are arcuate with a predetermined curvature. The semiconductor chip 206 which can be curved is mounted on the support means 204 by bonding only both side ends of its back surface to the top end surfaces of the upright wall portions 207 of the support means 204 and is kept curved. In the embodiment shown in Fig. 6, the curved surface that extends over the entire back surface of the semiconductor chip 206 does not need to be formed by the support means 204, whereby the support means 204 can be formed at a relatively low cost. However, when the support means 204 and/or the semiconductor chip 206 expands(s) or contract(s) slightly due to variations in environmental temperature, the curvature of the semiconductor chip 204 is apt to considerably change.

While several embodiments of the semiconductor device constituted according to the invention have been described in detail with reference to the accompanying drawings, it is to be understood that the invention is not limited thereto and various changes and modifications may be made without departing from the scope and spirit of the invention.

## Claims

1. A semiconductor device (2; 102; 202) comprising a support means (4; 104; 204) and a semiconductor chip (6; 106; 206) mounted on said support means (4;, 104; 204), wherein said semiconductor chip (6; 106; 206) has a capability of being curved, and is kept curved with a predetermined curvature by it being mounted on the support means (4; 104; 204).

2. The semiconductor device of claim 1, wherein said support means (4; 104; 204) has a curved surface (8; 108; 207) with a predetermined curvature, said semiconductor chip (6; 106; 206) is curved so that it extends along the curved surface (8; 108; 207), and the back surface of said semiconductor chip (6; 106; 206) is at least partially bonded to the curved surface (8; 108) by a bonding material.

3. The semiconductor device of claim 2, wherein the substantially entire back surface of said semiconductor chip (6; 106; 206) is bonded to the curved surface (8; 108; 207) by a bonding material.

4. The semiconductor device of one of the preceding claims, wherein said semiconductor chip (6; 106; 206) is made from silicon having a thickness of 20 to 100 µm.

5. The semiconductor device of claim 4, wherein said semiconductor chip (6; 106; 206) is made from silicon having a thickness of 30 to 50 µm.
